# EUROPEAN PATENT APPLICATION

(11) **EP 4 293 756 A1**
(43) Date of publication of application: **20.12.2023**
(21) Application number: 21925905.8
(22) Date of filing: 08.10.2021
(51) Int. Cl.: H01M 4/66, H01M 4/134, H01M 10/052, H01M 12/08, C23C 28/00, H01M 4/02

(54) **ANODE CURRENT COLLECTOR AND METAL BATTERY COMPRISING SAME**

(30) Priority: 09.02.2021 KR 20210018524
(71) Applicant: NEXTERIALS CO., LTD., Ulju-gun Ulsan 44919 (KR)
(72) Inventor: SHIN, Hyeon Suk, Ulju-gun, Ulsan 44919 (KR); LEE, Sang Young, Seoul 03722 (KR); KIM, Seung Hyeok, Ulju-gun, Ulsan 44919 (KR); KIM, Min Su, Ulju-gun, Ulsan 44919 (KR)
(74) Representative: ZBM Patents - Zea, Barlocci & Markvardsen
(86) International application number: PCT/KR2021/013927
(87) International publication number: WO 2022/173085

(57) **Abstract**

The present disclosure relates to an anode current collector and a metal battery, and more specifically, to an anode current collector and a metal battery including the same, the collector including: a two-dimensional material layer which is formed on at least a portion of at least one surface of a current collector substrate, and which has an atomic thickness; and a metal layer formed on at least a portion of the two-dimensional material layer. In addition, the present disclosure may further provide a method of manufacturing the anode current collector.

## Description

### Technical Field

The present disclosure relates to an anode current collector and a metal battery including the same.

### Background Art

Lithium secondary batteries, which exhibit the best energy density and output characteristics, have been widely commercialized. As the demand for electric vehicles and large-capacity power storage devices increases, various batteries capable of satisfying the demand have been developed. An analysis result shows that a lithium metal anode needs to be applied to realize an energy density of at least 400 watt-hours per kilogram (Wh/kg), and the development of technologies of using lithium metal as an anode to enhance the energy density of a secondary battery is actively ongoing.

Lithium metal batteries, which are secondary batteries that use lithium metal with a high capacity and low reduction potential as an anode, are being studied and developed in various forms such as lithium-air batteries or lithium-sulfur batteries, and are in the limelight as a next-generation energy battery system with a high energy density.

If lithium metal is used as an anode, a lithium layer with a dendrite structure may be formed in a process of depositing the lithium metal on a surface of a current collector. If lithium dendrites grow due to such a non-uniform lithium layer, a short circuit phenomenon may occur and dead Li, which does not contribute to the capacity, may be formed. In addition, due to the above lithium layer with the dendrite structure, a phenomenon in which the capacity and output characteristics of a battery are reduced occurs, which may lead to a difficulty in commercializing a lithium metal battery.

To overcome such issues, the development of technologies for forming a uniform lithium layer on a surface of a current collector is emerging, however, it is difficult to technically control a uniform lithium nucleation due to high nucleation overpotentials of the surface of the current collector.

### Disclosure of the Invention

### Technical Goals

To solve the above-mentioned problems, the present disclosure is to provide an anode current collector that has a surface modified to have a metal affinity and that may form a uniform and dense metal layer.

The present disclosure is to provide a metal battery that includes the anode current collector according to the present disclosure and that may realize a metal-based high energy density.

The present disclosure is to provide a method of manufacturing an anode current collector according to the present disclosure.

However, the technical goal obtainable from the present disclosure is not limited to those described above, and other goals not mentioned above can be clearly understood by one of ordinary skill in the art to which the present disclosure pertains from the following description.

### Technical Solutions

According to an embodiment of the present disclosure, there is provided an anode current collector including a current collector substrate; a two-dimensional material layer formed on at least a portion of at least one surface of the current collector substrate and having an atomic thickness; and a metal layer formed on at least a portion of the two-dimensional material layer.

According to an embodiment of the present disclosure, the current collector substrate may include at least one selected from a group consisting of Ni, Cu, Ti, V, Cr, Mn, Fe, Co, Zn, Mo, W, Ag, Au, Ru, Pt, Ir, Li, Al, Sn, Bi, Sb, and an alloy thereof; calcined carbon; and stainless steel.

According to an embodiment of the present disclosure, the current collector substrate may include a first component including Cu, Ni, Ti, stainless steel, or Al; and a second component (excluding the same element as in the first component) including at least one selected from a group consisting of Ni, Cu, Ti, V, Cr, Mn, Fe, Co, Zn, Mo, W, Ag, Au, Ru, Pt, Ir, Li, Al, Sn, Bi, Sb, and an alloy thereof.

According to an embodiment of the present disclosure, the current collector substrate may be a foil having a thickness of 5 micrometers (µm) to 100 µm.

According to an embodiment of the present disclosure, the two-dimensional material may include at least one of graphene, hexagonal boron nitride, and a transition metal compound.

According to an embodiment of the present disclosure, the two-dimensional material layer may have a thickness of 0.4 nanometers (nm) to 10 nm.

According to an embodiment of the present disclosure, the metal layer may be directly grown on the two-dimensional material layer by a deposition process. The metal layer may be directly grown by an electrochemical deposition.

According to an embodiment of the present disclosure, the metal layer may include at least one selected from a group consisting of: at least one metal selected from a group consisting of lithium (Li), sodium (Na), aluminum (Al), calcium (Ca), silver (Ag), gold (Au), sodium (Na), zinc (Zn), magnesium (Mg), and potassium (K); a sulfide including the metal; a halide; an oxide; an intermetallic compound; and an alloy.

According to an embodiment of the present disclosure, the metal layer may be free of a metal-containing dendrite structure. The metal layer may be a planar film.

According to an embodiment of the present disclosure, the metal layer may have a thickness of 1 nm to 100 µm.

According to an embodiment of the present disclosure, the metal layer may include a lithium metal, a lithium sulfide, a lithium halide, a lithium alloy, or both.

According to an embodiment of the present disclosure, the lithium alloy may include lithium; and at least one selected from a group consisting of sodium (Na), aluminum (Al), calcium (Ca), silver (Ag), gold (Au), sodium (Na), zinc (Zn), magnesium (Mg), and potassium (K).

According to an embodiment of the present disclosure, there is provided a metal battery including: an anode portion; a cathode portion; and an electrolyte between the anode portion and the cathode portion, wherein the anode portion includes an anode current collector. The anode current collector includes: a current collector substrate; a two-dimensional material layer formed on at least a portion of at least one surface of the current collector substrate and having an atomic thickness; and a metal layer formed on at least a portion of the two-dimensional material layer.

According to an embodiment of the present disclosure, the electrolyte may include a liquid electrolyte, a solid electrolyte, or both.

According to an embodiment of the present disclosure, the anode current collector may be an anodeless current collector in which the electrolyte contacts the metal layer.

According to an embodiment of the present disclosure, there is provided a method of manufacturing an anode current collector. The method includes: preparing a current collector substrate; forming a two-dimensional material layer having an atomic thickness on at least a portion of at least one surface of the current collector substrate; and forming a metal layer on at least a portion of the two-dimensional material layer.

According to an embodiment of the present disclosure, the forming of the two-dimensional material layer may include transferring the two-dimensional material layer onto the anode current collector.

According to an embodiment of the present disclosure, the forming of the two-dimensional material layer may include directly growing the two-dimensional material layer on the anode current collector by a deposition process.

According to an embodiment of the present disclosure, the forming of the metal layer may include directly growing the metal layer on the two-dimensional material layer by a deposition process.

### Effects

In the present disclosure, a metal layer with a flat and dense structure, for example, a lithium layer, in which nucleation overpotentials of a metal, for example, lithium, are reduced and in which a dendrite structure is suppressed on a surface of a current collector, may be formed on the surface of the current collector employing an anode structure. The metal layer having the above flat and dense structure may be applied as a metal anode, for example, a lithium metal anode. Moreover, a constant energy density and stability may be enhanced by preventing a decrease in capacity and output characteristics, and a high-energy metal battery, for example, a lithium metal battery, may be implemented.

In addition, the present disclosure may provide an anodeless current collector in which a uniform and dense metal layer that has an atomic thickness and a planar shape and that is surface-treated with a two-dimensional material capable of adsorbing metal atoms is formed, and may provide a metal battery, for example, a lithium metal battery, to which the anode current collector is applied.

### Brief Description of Drawings

FIG. 1 illustrates an example of a configuration of an anode current collector having a surface modified to be lithiophilic according to the present disclosure and an anode current collector in which a uniform lithium metal layer is formed, according to an embodiment of the present disclosure.
FIG. 2A is a scanning electron microscopy (SEM) image of a surface on which a lithium metal is deposited, showing a morphology of the lithium metal deposited on pristine Cu, according to an embodiment of the present disclosure.
FIG. 2B is a SEM image of a surface on which a lithium metal is deposited, showing a morphology of the lithium metal deposited on a hexagonal boron nitride (h-BN) monolayer/Cu, according to an embodiment of the present disclosure.
FIG. 2C is a SEM image of a surface on which a lithium metal is deposited, showing a morphology of the lithium metal deposited on a graphene monolayer/Cu, according to an embodiment of the present disclosure.
FIG. 3 illustrates results obtained by measuring nucleation overpotentials of current collectors according to an embodiment of the present disclosure, for a comparison of the results obtained before and after an h-BN layer is introduced on a current collector and types of current collectors.
FIG. 4A illustrates results obtained by measuring nucleation overpotentials of current collectors according to an embodiment of the present disclosure, for a comparison of voltage profiles according to types of two-dimensional materials (h-BN and graphene).
FIG. 4B illustrates results obtained by measuring nucleation overpotentials of current collectors according to an embodiment of the present disclosure, for a comparison of relative Li nucleation overpotentials according to types of two-dimensional materials (h-BN and graphene).
FIG. 5 illustrates Coulombic efficiency (CE) test results of current collectors according to an embodiment of the present disclosure, for a comparison of pristine Cu, h-BN monolayer/Cu, and graphene monolayer/Cu.
FIG. 6 illustrates full-cell C-rate measurement results according to an embodiment of the present disclosure.
FIG. 7 illustrates results obtained by measuring cycle characteristics of a full cell according to an embodiment of the present disclosure.

### Best Mode for Carrying Out the Invention

Hereinafter, embodiments of the present disclosure will be described in detail with reference to the accompanying drawings. In the description of the present disclosure, detailed description of well-known related functions or configurations will be omitted when it is deemed that such description will cause ambiguous interpretation of the present disclosure. In addition, the terminologies used herein are for the purpose of appropriately describing example embodiments of the present disclosure, and may vary depending on the intention of users or operators or customs in the art to which the present disclosure belongs. Therefore, terms used herein should be defined based on the content throughout the present specification. In the drawings, like reference numerals are used for like elements.

In the whole specification, when one member is positioned "on" another member, this not only includes a case that the one member is brought into contact with the other member, but also includes a case that another member exists between two members.

It will be understood throughout the whole specification that, when one part "includes" or "comprises" one component, the part does not exclude other components but may further include the other components.

The present disclosure relates to a project of a "two-dimensional van der Waals structure Material Chemistry Laboratory (Detailed Project Number: 2019R1A4A1027934, Assignment Unique Number: 1711108505, Project Name: Group research support (R&D), Name of Assignment Management (specialized) Institute: National Research Foundation of Korea, Research Period: March 1, 2020 to February 28, 2021)" supported by the Ministry of Science and ICT.

Hereinafter, an anode current collector, a metal battery, and a method of manufacturing an anode current collector according to the present disclosure will be described in detail with reference to embodiments and drawings. However, the present disclosure is not limited to the embodiments and drawings.

The present disclosure relates to an anode current collector. According to an embodiment of the present disclosure, the anode current collector may have a surface modified by a two-dimensional material to have a surface with a metal affinity, for example, a lithiophilic surface. By modifying the surface of the anode current collector to have the metal affinity, a dense and flat metal layer, for example, a lithium metal layer, without a dendrite structure may be formed on the surface of the current collector, a metal formation of the dendrite structure may be suppressed after deposition of the metal layer, and a constant energy density and stability may be shown.

According to an embodiment of the present disclosure, the anode current collector may include a current collector substrate; a two-dimensional material layer; and a metal layer.

According to an embodiment of the present disclosure, the current collector substrate may include at least one selected from a group consisting of Ni, Cu, Ti, V, Cr, Mn, Fe, Co, Zn, Mo, W, Ag, Au, Ru, Pt, Ir, Li, Al, Sn, Bi, Sb, and an alloy thereof; calcined carbon; and stainless steel, and may include, for example, a first component including Cu, Ni, Ti, stainless steel, or Al; and a second component (excluding the same element as in the first component) including at least one selected from a group consisting of Ni, Cu, Ti, V, Cr, Mn, Fe, Co, Zn, Mo, W, Ag, Au, Ru, Pt, Ir, Li, Al, Sn, Bi, Sb, and an alloy thereof. The second component may not include the same element as that of the first component, and may form a current collector substrate in the form of a mixture with the first component, a coating, an alloy, a composite, and the like.

In an example, the current collector substrate may be a foil, a thin film, a film, or a sheet and may have a thickness of 5 micrometers (µm) to 100 µm. If the thickness of the current collector substrate is within the above thickness range, electrons may be advantageously transferred due to a high electrical conductivity of the current collector substrate, and a current collector may be used as a current collector for a lithium metal battery with a high energy density through lithiophilic surface modification.

According to an embodiment of the present disclosure, the two-dimensional material layer may be used to modify a surface of the current collector substrate to be lithiophilic, to implement a uniform metal, for example, lithium nucleation, by reducing nucleation overpotentials of a surface of the current collector and to form a uniform and flat metal deposition film, for example, a lithium deposition layer.

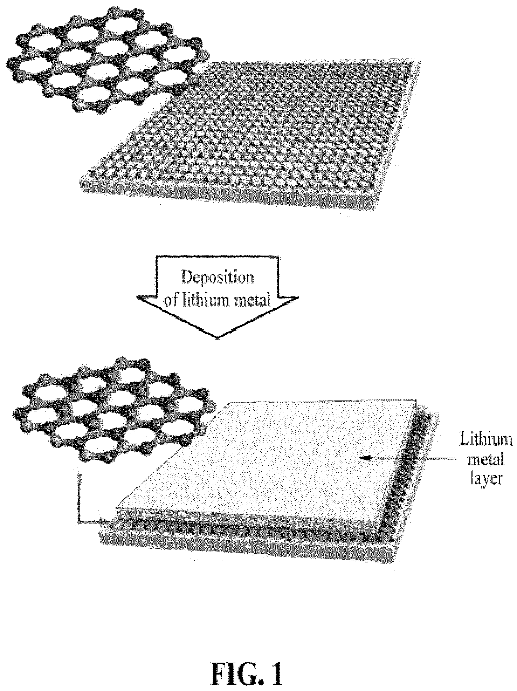

In an example, the two-dimensional material layer may be formed on at least a portion of at least one surface of the current collector substrate, may have an atomic thickness, may include at least one of graphene, hexagonal boron nitride, and a transition metal compound, and may desirably be hexagonal boron nitride. The two-dimensional material layer may control a metal affinity of the metal layer. In other words, referring to FIG. 1, a hexagonal boron nitride may control a lithium affinity through an introduction of a hexagonal boron nitride monolayer. When a hexagonal boron nitride monolayer with a few defects is introduced on the current collector substrate, electron transfer from the current collector substrate may be possible, which may enable lithium to be deposited directly on the hexagonal boron nitride. In addition, boron and nitrogen with a few defects and different electronegativities may be extremely regularly arranged on the current collector substrate, and accordingly, uniform metal deposition, for example, lithium metal deposition, may be possible. Due to a difference in polarity of hexagonal boron nitride, lithium may be easily deposited and uniform lithium nucleation may be induced.

In an example, the two-dimensional material layer may have a thickness of 0.4 nanometers (nm) to 10 nm. When the thickness of the two-dimensional material layer is within the above range, adsorption of lithium atoms may be advantageous, and an electronic conductivity in a vertical direction from the current collector substrate may be adjusted, thereby controlling a deposition rate of a metal layer, for example, a lithium metal layer, and assisting in a formation of a uniform lithium metal layer.

According to an embodiment of the present disclosure, the metal layer may be formed on at least a portion of the two-dimensional material layer, and may be directly grown on the two-dimensional material layer by a deposition process. Referring to FIG. 1, lithium nucleation resistance of the lithium metal layer may be greatly reduced on the two-dimensional material layer, so that deposition of lithium with a dendrite structure may be suppressed, to enable uniform lithium metal deposition and uniform lithium nucleation in an atomic unit and large area, thereby forming a large-area lithium metal layer. In addition, since the lithium metal layer is uniformly and densely deposited, a side reaction may be suppressed and a formation and growth of lithium dendrites may be suppressed at high current.

In an example, the metal layer may be directly grown on the surface of the current collector modified by the two-dimensional material layer, so that a metal layer with a flat and dense structure in which nucleation overpotentials of a metal are reduced and in which a dendrite structure is suppressed on the surface of the current collector may be formed. In other words, a metal layer of a planar film with a dense and flat structure may be formed, so that a constant energy density and stability may be enhanced. In addition, the metal layer may suppress a formation of a metal dendrite structure, and accordingly, the metal layer may partially have a metal dendrite structure or may be free of the metal dendrite structure. The metal layer may be formed as a uniform and dense film to suppress a side reaction at high current, and a formation of dendrites may be suppressed during operating of a battery. For example, a lifespan of a lithium metal battery in which hexagonal boron nitride (h-BN) is introduced may be three times greater than that of an existing lithium metal battery in which h-BN is not introduced.

In an example, the metal layer may include at least one selected from a group consisting of: at least one metal selected from a group consisting of lithium (Li), sodium (Na), aluminum (Al), calcium (Ca), silver (Ag), gold (Au), sodium (Na), zinc (Zn), magnesium (Mg), and potassium (K); a compound containing the metal (or metal element); and an alloy. For example, the compound containing the metal (or metal element) may be a sulfide, a halide, an oxide, and the like.

In an example, the metal layer may be a lithium metal layer, and the lithium metal layer may include at least one selected from a group consisting of a lithium metal, a lithium-containing compound, a lithium-containing intermetallic compound, and a lithium alloy.

The lithium-containing compound may be a sulfide, a halide, an oxide, and the like, and may be, for example, a lithium sulfide (e.g., LiS), a lithium halide (e.g., LiF), a lithium oxide (e.g., LiO₂), and the like.

The lithium alloy and intermetallic compound may include, for example, lithium; and at least one selected from a group consisting of sodium (Na), aluminum (Al), calcium (Ca), silver (Ag), gold (Au), sodium (Na), zinc (Zn), magnesium (Mg), and potassium (K).

In addition, the lithium metal layer may further include at least one metal (or element) selected from a group consisting of sodium (Na), aluminum (Al), calcium (Ca), silver (Ag), gold (Au), sodium (Na), zinc (Zn), magnesium (Mg), and potassium (K).

In an example, the metal layer may have a thickness of 1 nm to 100 µm; 10 nm to 50 µm; or 1 µm to 40 µm; or 10 µm to 35 µm, or may have an atomic thickness. When the thickness of the metal layer is included within the above thickness range or the metal layer is formed with a thinner thickness within the above thickness range, the metal layer may assist in increasing the energy density in units of cells.

The present disclosure relates to a metal battery. According to an embodiment of the present disclosure, the lithium metal battery may include: an anode portion; a cathode portion; and an electrolyte between the anode portion and the cathode portion. The anode current collector according to the present disclosure may be applied to the lithium metal battery, and accordingly, the lithium metal battery may exhibit a high energy density, a high stability and long lifespan characteristics.

According to an embodiment of the present disclosure, the metal battery may be lithium (Li), sodium (Na), aluminum (Al), calcium (Ca), silver (Ag), gold (Au), sodium (Na), zinc (Zn), magnesium (Mg), or potassium (K)-based metal battery.

According to an embodiment of the present disclosure, the anode may include an anode current collector according to the present disclosure, and the anode current collector may be an anodeless current collector by applying the metal layer.

According to an embodiment of the present disclosure, the electrolyte may include an electrolyte applicable to a metal battery known in a technical field art of the present disclosure, may be formed between the cathode and the metal layer of the anode current collector, and may include a liquid electrolyte, a solid electrolyte, or both. A separator may be further included between the electrolyte and the cathode. The separator may include a liquid electrolyte, a solid electrolyte, or both, and may be applied as a function of the electrolyte.

In an example, the electrolyte may form an anodeless metal battery in contact with the metal layer and may form, for example, an anodeless lithium metal battery.

According to an embodiment of the present disclosure, as the cathode, all cathodes applicable to a metal battery known in the technical field of the present disclosure may be applied without limitation, and the cathode may be a high-capacity cathode such as an oxide or a sulfide. The cathode may further include a cathode current collector.

In an example, the metal battery may be operated and driven by introducing a configuration known in the technical field of the present disclosure without departing from the aspect and scope of the present disclosure, and further description thereof is omitted herein.

The present disclosure relates to a method of manufacturing an anode current collector according to the present disclosure. According to an embodiment of the present disclosure, in the method, a surface of a current collector substrate may be modified to be lithiophilic by a two-dimensional material, and a metal layer may be directly grown on the anode current collector, to form a uniform and dense lithium metal film in which a generation of a dendrite structure is suppressed.

According to an embodiment of the present disclosure, the method may include: a step of preparing a current collector substrate; a step of forming a two-dimensional material layer having an atomic thickness on at least a portion of at least one surface of the current collector substrate; and a step of forming a metal layer on at least a portion of the two-dimensional material layer.

According to an embodiment of the present disclosure, the step of forming the two-dimensional material layer may be performed by a physical method or a chemical method.

For example, the physical method may include a step of transferring the two-dimensional material layer onto the anode current collector, and a two-dimensional material grown on a separate substrate may be exfoliated by an electrical exfoliation scheme and transferred onto the current collector substrate. A two-dimensional material (or film) and a method of transferring the two-dimensional material known in the technical field of the present disclosure may be applied to the step of transferring the two-dimensional material layer, and further description thereof is omitted herein.

For example, the chemical method may include a step of directly growing the two-dimensional material layer on the anode current collector by a deposition process, and the two-dimensional material may be directly grown on the current collector substrate by a chemical vapor deposition (CVD). As the chemical method, an atomic layer deposition (ALD), a plasma atomic layer deposition, a plasma enhanced chemical vapor deposition (PECVD), and the like may be further used.

According to an embodiment of the present disclosure, the step of forming the metal layer may be directly growing the metal layer on the two-dimensional material layer by a deposition process, and the metal layer may be directly grown on the current collector substrate having the surface modified by the two-dimensional layer, using, for example, an electrochemical deposition, a physical adsorption (e.g., press, etc.), alloying (e.g., a melting and alloying reaction, such as "melting & alloy"), and the like.

The present disclosure may provide a method of manufacturing a metal battery by introducing or utilizing the anode current collector or the method of manufacturing the anode current collector according to the present disclosure. For example, a step of preparing the anode current collector; a step of preparing an electrolyte and/or a separator; a step of preparing a cathode; and a step of connecting, combining, attaching, and/or compressing the anode current collector, the electrolyte and/or separator, and the cathode by arranging the anode current collector, the electrolyte and/or separator, and the cathode in order.

Although the present disclosure is described with reference to desired embodiments, the present disclosure is not limited thereto. Various changes and modifications may be made without departing from the spirit and scope of the present disclosure disclosed in the following claims, the detailed description, and the accompanying drawings.

### Examples

### Preparation Example 1

An h-BN monolayer was prepared and transferred onto a current collector.

### Preparation Example 2

A graphene monolayer/Cu was prepared by directly growing and transferring a graphene monolayer onto a Cu foil.

### Preparation Example 3

An h-BN monolayer/Cu was formed by directly growing h-BN on a Cu foil by a CVD.

In the preparation examples, graphene and h-BN were prepared with reference to a prior paper (Nano Lett. 2013, 13, 1834-1839).

### Preparation Example 4

### Fabrication of Electrochemical Cell including Lithium Metal - Anode Current Collector

A lithium metal layer having a desired thickness was deposited on each of two-dimensional material layers of the anode current collectors prepared in Preparation Examples 1 to 3, through an electrochemical deposition process, to fabricate an electrochemical cell. Next, a separator and an electrolyte were added.

### Electrolyte: 1 M LiTFSI in 1,3-dioxolane (DOL)/1,2-dimethyoxyethane (DME) = 1/1 (v/v)

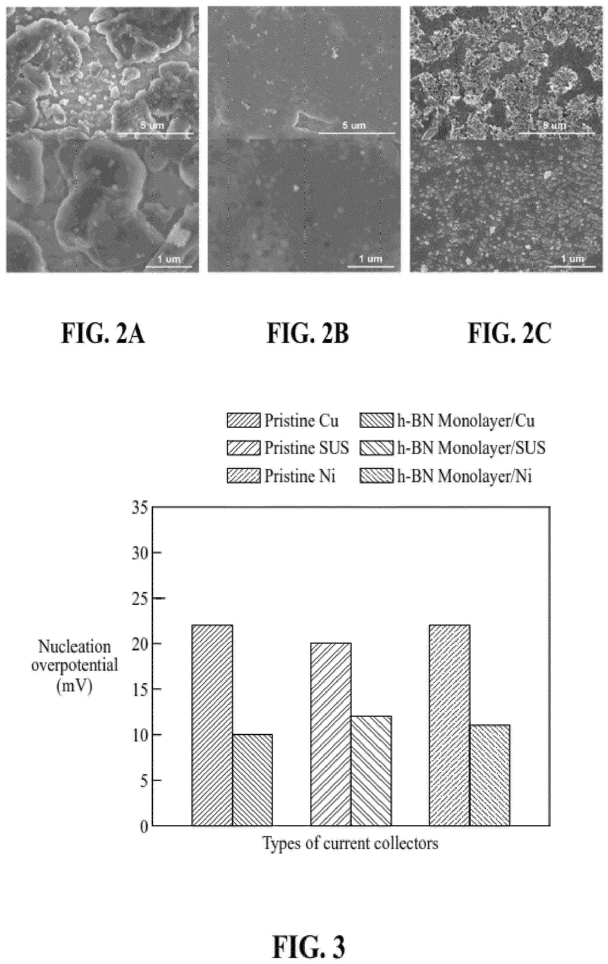

Electrochemical characteristics and surface morphologies of prepared current collectors are analyzed and shown in FIGS. 2A to 7 below.

FIGS. 2A, 2B, and 2C illustrate scanning electron microscopy (SEM) images of surfaces on which lithium metals are deposited according to an embodiment of the present disclosure. The SEM images were obtained after Li metal (0.1 mAh/cm²) was deposited on pristine Cu (FIG. 2A), h-BN monolayer/Cu (FIG. 2B), and graphene monolayer/Cu (FIG. 2C), and morphologies were compared. It can be confirmed that the most uniform Li metal deposition was achieved on the h-BN monolayer/Cu.

In other words, an image of a lithium layer formed on a Cu current collector has a dendrite structure, whereas an image of a lithium layer formed on a hexagonal boron nitride/Cu current collector does not have a dendrite structure, and thus it can be confirmed that a dense and flat lithium layer is formed on a surface of the current collector.

### Measurement Conditions

Electrolyte: 1 M LiTFSI in 1,3-dioxolane (DOL)/1,2-dimethyoxyethane (DME) (5/5, v/v) + 2 wt% LiNO₃
Current Density: 10 uA/cm²

FIG. 3 illustrates results obtained by measuring nucleation overpotentials of current collectors according to an embodiment of the present disclosure, for a comparison of the results obtained before and after an h-BN layer is introduced on a current collector and types of current collectors.

Overpotentials according to whether h-BN was introduced and the types of current collectors (Cu, Ni, and SUS) were compared, and it can be confirmed that nucleation overpotentials decrease after the introduction of h-BN regardless of the types of current collectors.

### Measurement Conditions

Directly grown h-BN was used for a Cu current collector, and transferred h-BN was used for a Ni current collector and an SUS current collector.
Electrolyte: 1 M LiTFSI in DOUDME (5/5, v/v) + 2 wt% LiNO₃
Current Density: 10 uA/cm²

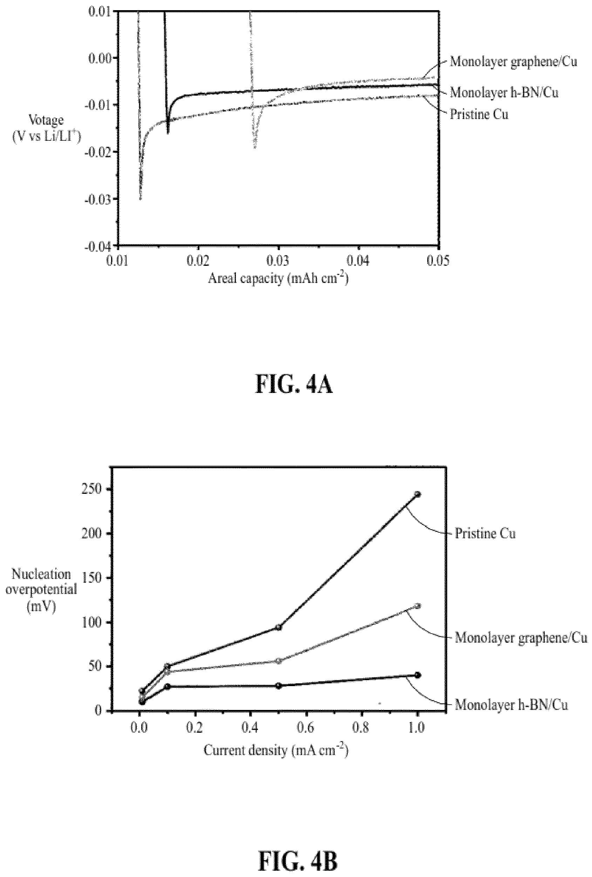

FIGS. 4A and 4B illustrate results obtained by measuring nucleation overpotentials of current collectors according to an embodiment of the present disclosure, for a comparison of the results according to types of two-dimensional materials (h-BN and graphene). A current collector with an introduced h-BN monolayer shows nucleation overpotentials less than those of a graphene monolayer, thereby inducing an increase in Li binding energy.

### Measurement Conditions

Current Collector: Pristine Cu, h-BN Monolayer/Cu, Graphene Monolayer/Cu
(a) Voltage profiles are compared during a deposition of Li on Cu, h-BN/Cu, and graphene/Cu at a current density of 0.01 mA cm⁻² (FIG. 4A).
(b) Relative Li nucleation overpotentials of three electrodes were measured at different current densities (0.01, 0.10, 0.50 and 1.0 mA cm⁻²) (FIG. 4B).

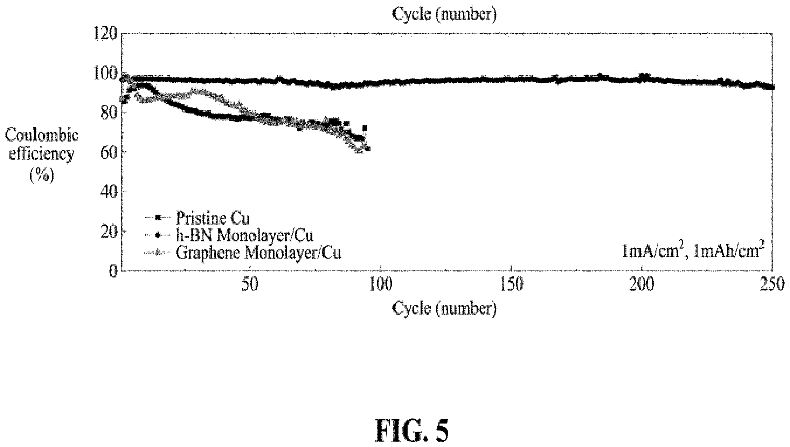

FIG. 5 illustrates Coulombic efficiency (CE) test results of current collectors according to an embodiment of the present disclosure. The best lifespan characteristics are shown in the h-BN monolayer/Cu, and the CE of the h-BN monolayer/Cu remains unchanged, which indicates that a reversible reaction of Li is constant and that constant performance may be maintained even during repeated charging and discharging of a battery.

### Measurement Conditions

Current Collector: Pristine Cu, h-BN Monolayer/Cu, Graphene Monolayer/Cu
Electrolyte: 1 M LiTFSI in DOUDME (5/5, v/v) + 2 wt% LiNO₃

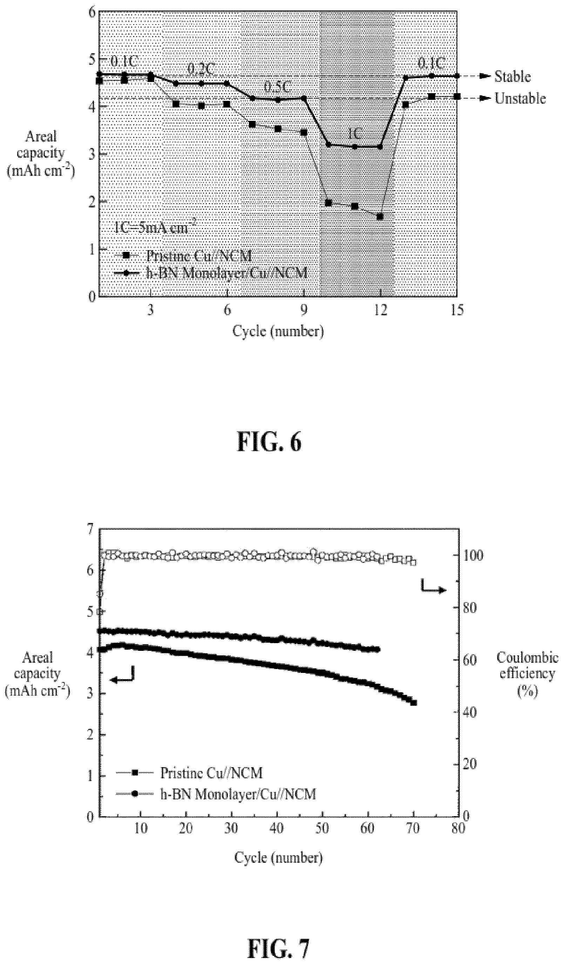

FIG. 6 illustrates full-cell C-rate measurement results according to an embodiment of the present disclosure, for a comparison of full-cell C-rate characteristics (NP Ratio = 1) according to whether an h-BN monolayer was introduced. A C-rate refers to a charge/discharge rate, and FIG. 6 shows that constant performance is maintained despite multiple charge/discharge cycles when the h-BN monolayer is introduced. In other words, it can be confirmed that when the h-BN monolayer is introduced, rate characteristics are enhanced and stable utilization of metal even at a high rate is possible.

### Measurement Conditions

Current Collector: Pristine Cu and h-BN Monolayer/Cu
Electrolyte: 1 M LiPF₆ in EC/DEC (5/5, v/v) + 10 wt% FEC + 1 wt% VC
Charge Current Density: 0.1 C

FIG. 7 illustrates results obtained by measuring cycle characteristics of a full cell according to an embodiment of the present disclosure, and full cell C-rate characteristics (NP Ratio = 1) are compared according to whether an h-BN monolayer is introduced (pristine Cu, and h-BN monolayer/Cu). It can be confirmed that when the h-BN monolayer is introduced, rate characteristics are enhanced and stable utilization of metal even at a high rate is possible.

### Measurement Conditions

Current Collector: Pristine Cu and h-BN Monolayer/Cu
Electrolyte: 1 M LiPF₆ in EC/DEC (5/5, v/v) + 10 wt% FEC + 1 wt% VC
Charge/Discharge Current Densities: 0.1 C/0.2 C

The present disclosure may provide an anode current collector that may suppress a deposition of lithium with a lithium dendrite structure and may reduce lithium nucleation resistance through improvement of a lithium affinity of a surface of a current collector, and may allow lithium to be uniformly deposited even at a high current density. In addition, the anode current collector may be used as an anodeless current collector of a lithium metal battery with a high energy density.

While the embodiments are described with reference to drawings, it will be apparent to one of ordinary skill in the art that various alterations and modifications in form and details may be made in these embodiments without departing from the spirit and scope of the claims and their equivalents. For example, suitable results may be achieved if the described techniques are performed in a different order, and/or if described components are combined in a different manner, and/or replaced or supplemented by other components or their equivalents. Therefore, other implementations, other embodiments, and equivalents to the claims are also within the scope of the following claims.

## Claims

1. An anode current collector comprising:
a current collector substrate;
a two-dimensional material layer formed on at least a portion of at least one surface of the current collector substrate and having an atomic thickness; and
a metal layer formed on at least a portion of the two-dimensional material layer.

2. The anode current collector of claim 1, wherein the current collector substrate comprises at least one selected from a group consisting of Ni, Cu, Ti, V, Cr, Mn, Fe, Co, Zn, Mo, W, Ag, Au, Ru, Pt, Ir, Li, Al, Sn, Bi, Sb, and an alloy thereof; calcined carbon; and stainless steel.

3. The anode current collector of claim 1, wherein the current collector substrate comprises:
a first component including Cu, Ni, Ti, stainless steel, or Al; and
a second component (excluding a same element as in the first component) including at least one selected from a group consisting of Ni, Cu, Ti, V, Cr, Mn, Fe, Co, Zn, Mo, W, Ag, Au, Ru, Pt, Ir, Li, Al, Sn, Bi, Sb, and an alloy thereof.

4. The anode current collector of claim 1, wherein the current collector substrate is a foil having a thickness of 5 micrometers (µm) to 100 µm.

5. The anode current collector of claim 1, wherein the two-dimensional material comprises at least one of graphene, hexagonal boron nitride, and a transition metal compound.

6. The anode current collector of claim 1, wherein the two-dimensional material layer has a thickness of 0.4 nanometers (nm) to 10 nm.

7. The anode current collector of claim 1, wherein
the metal layer is directly grown on the two-dimensional material layer by a deposition process, and
the metal layer is directly grown by an electrochemical deposition.

8. The anode current collector of claim 1, wherein the metal layer comprises at least one selected from a group consisting of:
at least one metal selected from a group consisting of lithium (Li), sodium (Na), aluminum (Al), calcium (Ca), silver (Ag), gold (Au), sodium (Na), zinc (Zn), magnesium (Mg), and potassium (K);
a sulfide including the metal;
a halide;
an oxide;
an intermetallic compound; and
an alloy.

9. The anode current collector of claim 1, wherein
the metal layer is free of a metal-containing dendrite structure, and
the metal layer is a planar film.

10. The anode current collector of claim 1, wherein the metal layer has a thickness of 1 nm to 100 µm.

11. The anode current collector of claim 1, wherein the metal layer comprises a lithium metal, a lithium sulfide, a lithium halide, a lithium alloy, or both.

12. The anode current collector of claim 11, wherein the lithium alloy comprises:
lithium; and
at least one selected from a group consisting of sodium (Na), aluminum (Al), calcium (Ca), silver (Ag), gold (Au), sodium (Na), zinc (Zn), magnesium (Mg), and potassium (K).

13. A metal battery comprising:
an anode portion;
a cathode portion; and
an electrolyte between the anode portion and the cathode portion,
wherein the anode portion comprises an anode current collector,
wherein the anode current collector comprises:
a current collector substrate;
a two-dimensional material layer formed on at least a portion of at least one surface of the current collector substrate and having an atomic thickness; and
a metal layer formed on at least a portion of the two-dimensional material layer.

14. The metal battery of claim 13, wherein the electrolyte comprises a liquid electrolyte, a solid electrolyte, or both.

15. The metal battery of claim 13, wherein the anode current collector is an anodeless current collector in which the electrolyte contacts the metal layer.

16. The metal battery of claim 13, wherein the metal battery is a lithium metal battery.

17. A method of manufacturing an anode current collector, the method comprising:
preparing a current collector substrate;
forming a two-dimensional material layer having an atomic thickness on at least a portion of at least one surface of the current collector substrate; and
forming a metal layer on at least a portion of the two-dimensional material layer.

18. The method of claim 17, wherein the forming of the two-dimensional material layer comprises transferring the two-dimensional material layer onto the anode current collector.

19. The method of claim 17, wherein the forming of the two-dimensional material layer comprises directly growing the two-dimensional material layer on the anode current collector by a deposition process.

20. The method of claim 17, wherein the forming of the metal layer comprises directly growing the metal layer on the two-dimensional material layer by a deposition process.
